(19)

**Europäisches Patentamt**
**European Patent Office**
**Office européen des brevets**

(11) **EP 4 556 914 A1**

(12) **EUROPEAN PATENT APPLICATION**

(43) Date of publication:
**21.05.2025 Bulletin 2025/21**

(51) International Patent Classification (IPC):
**G01R 27/02** (2006.01)   **B60L 3/00** (2019.01)

(21) Application number: **24212623.3**

(22) Date of filing: **13.11.2024**

(52) Cooperative Patent Classification (CPC):
**G01R 27/025; B60L 3/0046; B60L 3/0069;**
G01R 31/396

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **15.11.2023  IT 202300024207**

(71) Applicant: **FERRARI S.p.A.**
**41100 Modena (IT)**

(72) Inventors:
• **SCANDURRA, Antonio**
  **41100 Modena (IT)**
• **BETRO', Roberto**
  **41100 Modena (IT)**
• **DE ANGELIS, Alessandro**
  **41100 Modena (IT)**
• **TRONCOSO, Matias**
  **41100 Modena (IT)**
• **ROSSETTI, Nicola**
  **41100 Modena (IT)**

(74) Representative: **Studio Torta S.p.A.**
**Via Viotti, 9**
**10121 Torino (IT)**

(54) **ISOLATION RESISTANCE EVALUATION SYSTEM FOR A HIGH VOLTAGE BATTERY, IN PARTICULAR FOR AN ELECTRIC VEHICLE**

(57)   An isolation resistance system for a battery (5) of a vehicle (1) having a battery pack (8) with a plurality of electrolytic cells (12) connected in series between a positive terminal (HV$^+$) and a negative terminal (HV-). A ground fault detection stage (30) is coupled to the positive and negative terminals and consists of: a first circuit branch (32), electrically coupled between the negative terminal and a reference terminal (GND), connected to the ground of the vehicle (1); and a second circuit branch (33), electrically coupled between the positive terminal and the reference terminal (GND). The first and the second circuit branches implement a respective resistive divider defining a negative output terminal (Out$^-$), respectively, a positive output terminal (Out$^+$), of the ground fault detection stage having, in use, a respective output voltage ($V_{Out}^-$, $V_{Out}^+$). A control unit (31) operatively coupled to the negative and positive output terminals determines an isolation resistance value ($R_{iso}$) associated with an isolation loss of the battery pack and locates an isolation loss position within the battery pack, as a function of the values of the output voltages ($V_{Out}^-$, $V_{Out}^+$) at the positive and negative output terminals of the ground fault detection stage (30).

FIG. 3

EP 4 556 914 A1

**Description**

CROSS-REFERENCE TO RELATED APPLICATIONS

This patent application claims priority from Italian patent application no. 102023000024207 filed on November 15, 2023, the entire disclosure of which is incorporated herein by reference.

TECHNICAL FIELD

The present solution relates to an isolation resistance evaluation system for a high-voltage battery (HVB), in particular for an electrically driven, hybrid or fully electric vehicle, so called BEV (Battery Electric Vehicle).

This solution may find preferable application in a BMS (Battery Management System) module provided with a Ground Fault Detection (GFD) system of an electric or hybrid vehicle having a high-voltage battery pack, to which the following discussion will make explicit reference without any loss of generality.

STATE OF THE ART

As is known, electric or hybrid motor vehicles are provided with an electric or hybrid drive assembly, which is designed to drive at least one wheel resting on the ground; a high-voltage, rechargeable battery pack, which is designed to accumulate a given amount of electrical energy to supply the electric or hybrid drive assembly; and an electronically controlled inverter, which is coupled between the battery pack and the drive assembly and is designed to transform, based on commands given by the driver of the vehicle, the direct current electrical energy coming from the battery pack into alternating current for the drive assembly.

In a known manner, the battery pack is internally provided with a management module, so-called BMS module, which interacts with the vehicle electronics and is designed to manage the operation and monitor the operating state of the battery pack, for example so as to avoid operation beyond safe conditions.

In particular, the BMS module is designed to control and manage the group of electrochemical cells of the battery pack, monitoring their charge status, temperature, voltage and/or other parameters, in order, for example, to balance the charge status in case of an unbalance between the various electrochemical cells.

Given that the battery packs of current motor vehicles may even reach nominal voltages of 800 V (generally operating at high voltages, ranging between 400 and 800 V), it is important to be able to detect any ground faults of the battery pack that may compromise the electrical isolation and be hazardous for people and/or the vehicle's low-voltage circuits that share the same ground connection.

These faults may, for example, be due to ageing of the electrical components, various kinds of stress (mechanical, electrical, thermal, or, in general, environmental) or to accidents to which the battery pack may be subjected, such as, for example, the puncturing of a corresponding sealed container in which the electrolytic cells are housed. When a ground fault occurs, a significant reduction in the electrical resistance associated with the isolation results; this entails the flow of a given leakage current, which may not be negligible.

It is, therefore, envisaged that the battery packs are equipped with ground fault detection circuits that are able to assess (potentially by means of suitable estimation) the electrical resistance between the positive pole of the battery pack and ground and/or between the negative pole of the same battery pack and ground, in particular operating conditions of the battery pack specified by the current regulations.

These ground fault detection circuits may, advantageously, be included in the BMS module of the high-voltage battery. In this case, the BMS module thus also has the function of monitoring the above-mentioned isolation resistance of the battery pack, being, for example, configured to interrupt, by means of suitable circuit interruption elements, the supply of loads by the same battery pack if there is a change in the isolation resistance that potentially is indicative of a ground fault.

This Applicant has realized that, despite the important function performed, the above-mentioned ground fault detection circuits currently may only provide an overall indication of the electrical isolation of the battery pack and, at the most, a qualitative evaluation of the state of electrical isolation inside the same battery pack, with the operating limits that derive from this.

In particular, known solutions do not enable to locate possible isolation losses inside the battery pack, being, at most, only able to determine whether the isolation inside the battery pack has deteriorated and, if so, to signal the need to replace the whole battery pack.

OBJECT OF THE INVENTION

The aim of the present invention is, in general, to overcome the limitations associated with the current solutions and, in particular, to provide a solution for evaluating the isolation resistance of a high-voltage battery, in particular for an electric motor vehicle, which is able to estimate the isolation resistance and, in addition, locate a position of the electrolytic cell inside the battery pack where the electric isolation is damaged or, in any case, compromised.

In view of the object indicated above, a system as defined in the attached claims is provided, according to the present invention.

BRIEF DESCRIPTION OF THE DRAWINGS

The present invention will now be described with reference to the attached drawings that illustrate a nonlimiting embodiment thereof, in which:

- Figure 1 is a schematic perspective view of an electric or hybrid motor vehicle provided with a battery pack having a BMS module, with parts removed for clarity;
- Figure 2 is a block diagram of a high-voltage battery of the motor vehicle of Figure 1; and
- Figure 3 is a circuit diagram of an isolation resistance evaluation system for the high-voltage battery of Figure 2.

DETAILED DESCRIPTION OF THE EMBODIMENTS

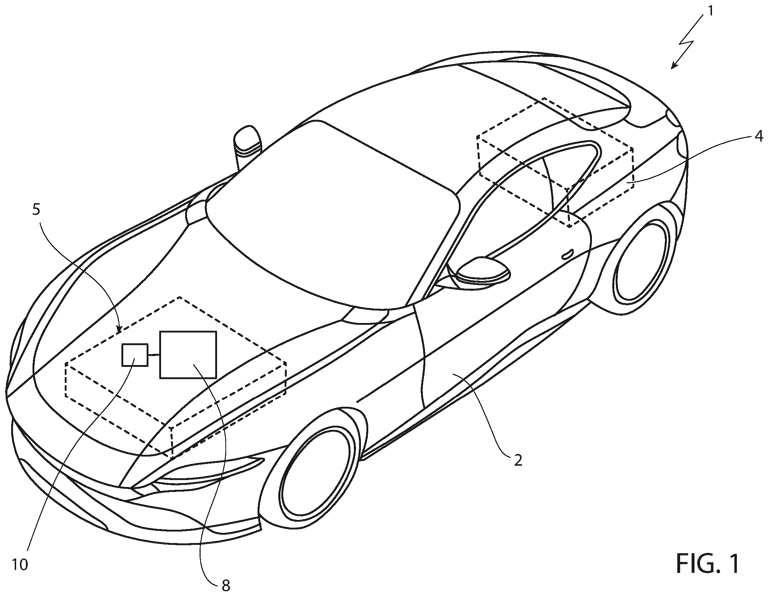

In Figure 1, reference 1 denotes, as a whole, a vehicle, in particular an electric or hybrid motor vehicle that has a body 2 resting on the ground by means of wheels 3 and comprising: an electric or hybrid drive assembly 4, including at least one synchronous or asynchronous electric motor, designed to drive in rotation at least one of the wheels 3; and a rechargeable, high-voltage battery (HVB) 5 that is able to accumulate a given quantity of electrical energy to supply the above-mentioned drive assembly 4.

The drive assembly 4 and the high-voltage battery 5 are housed inside the body 2, in the example illustrated the electric or hybrid drive assembly 4 being positioned in the rear part and the high-voltage battery 5 in the front part of the body 2.

In a known manner, not illustrated herein, an electrical unit, in particular including an electronically controlled inverter, is coupled between the high-voltage battery 5 and the drive assembly 4 to transform, based on commands given by the driver of the vehicle, the direct current electrical energy coming from the high-voltage battery 5 into alternating current electrical energy for the drive assembly 4.

The high-voltage battery 5 has, for example, a nominal capacity greater than or equal to 50 kWh and a nominal voltage ranging between 400 V and 800 Volt, in particular equal to 800 V.

As schematically shown in the above-mentioned Figure 1, the high-voltage battery 5 internally comprises a battery pack 8 and a BMS module 10, operationally coupled to the battery pack 8, to manage and supervise its operation.

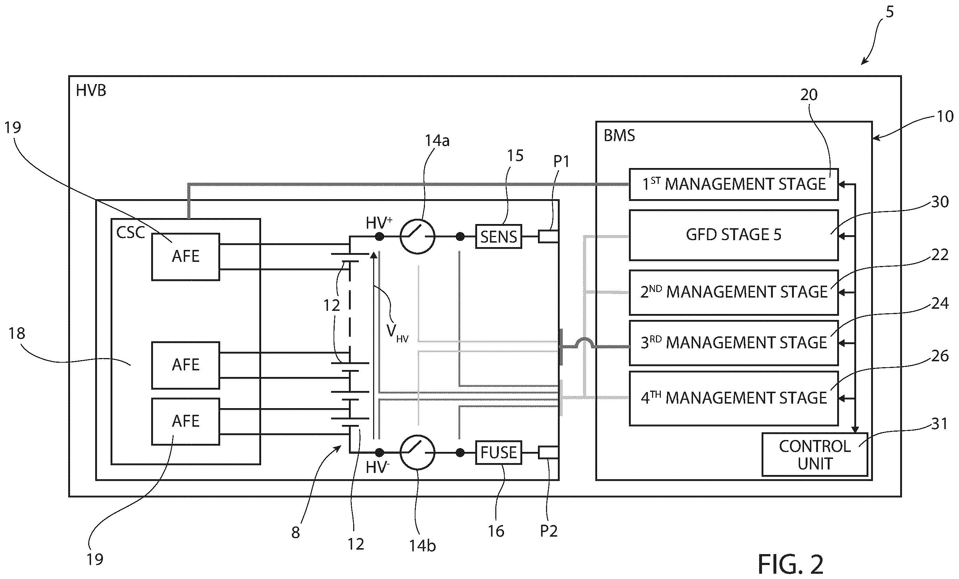

Figure 2 schematically shows, in a more detailed manner, a possible implementation of the above-mentioned high-voltage battery 5.

In particular, the battery pack 8 consists of a given number of modules or electrochemical cells 12, connected in series between a positive terminal $HV^+$ and a negative terminal $HV^-$, between which a battery voltage $V_{HV}$ is provided, which has a high value, for example in the range of 400 - 800 V.

In the embodiment illustrated, a first circuit interruption element (contactor) 14a is arranged between the positive terminal $HV^+$ and a positive output node $P_1$ of the battery pack 8, by means of the interposition of a current sensor element 15.

Similarly, a second circuit interruption element (contactor) 14b is arranged between the negative terminal $HV^-$ and a negative output node $P_2$ of the battery pack 8, by means of the interposition, in this case, of a fuse element 16.

The above-mentioned positive and negative output nodes $P_1$, $P_2$ are coupled to a high-voltage output bus, here not illustrated, of the battery pack 8, designed to transport electrical energy towards loads (in particular towards the electric or hybrid drive assembly 4).

The battery pack 8 also comprises a Cell Supervisor Circuit (CSC) 18, comprising a plurality of Analog Front End (AFE) stages 19, each coupled to a respective electrochemical cell 12. This supervisor circuit 18 has, among other features, the function of monitoring the voltage of the individual electrochemical cells 12 and balancing the voltages of the same electrochemical cells 12.

In the implementation illustrated, the BMS module 10 comprises:

a first management stage 20, coupled to the cell supervisor circuit 18 and configured to manage operation thereof;
a second management stage 22, coupled to the above-mentioned, high-voltage bus and configured to manage operation thereof;
a third management stage 24, coupled to the first and second circuit interruption elements 14a, 14b and configured to manage operation of the same circuit interruption elements 14a, 14b; and

a fourth management stage 26, coupled to the current sensor element 15 and to the fuse element 16 and configured to manage their operation.

The BMS module 10 also comprises a Ground Fault Detection (GFD) stage 30 coupled to the above-mentioned positive HV⁺ and negative HV⁻ terminals of the battery pack 8 and configured to perform isolation resistance evaluations for the high-voltage battery 5.

In particular, according to one aspect of this solution, the ground fault detection stage 30 is configured to estimate the isolation resistance towards the ground and, in addition, locate inside the battery pack 8 a position of the electrochemical cell 12 where the electrical isolation is damaged or, in any case, compromised.

The above-mentioned BMS module 10 further comprises a control unit 31, having a micro-processor, micro-controller, or similar digital processing unit, operationally coupled to the above-mentioned first, second, third, and fourth management stages 20, 22, 24, 26 and to the above-mentioned GFD stage 30, so as to control operation and functioning thereof, also as a function of controls received from outside, for example from an Electronic Control Unit (ECU) of the motor vehicle (not illustrated here).

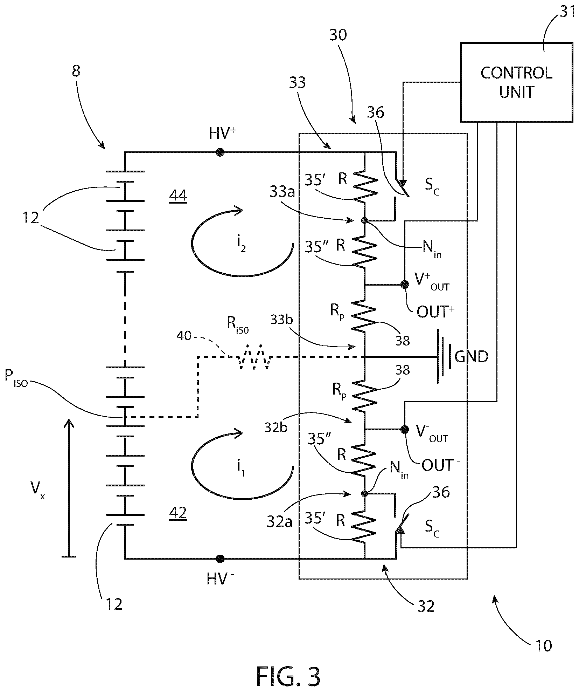

Specifically, and with reference to Figure 3, according to one embodiment of this solution, the above-mentioned GFD stage 30 comprises a first circuit branch 32, electrically connected between the negative terminal HV⁻ of the battery pack 8 and a reference terminal GND, connected to the ground of the vehicle 1 (not illustrated here; for example, this reference terminal GND may be connected to the body 2, or frame, of the above-mentioned vehicle 1); and a second circuit branch 33 electrically connected between the positive terminal HV⁺ of the battery pack 8 and the same reference terminal GND.

Each of the first and the second circuit branches 32, 33 implements a resistive divider between the negative terminal HV⁻, respectively positive terminal HV⁺, of the battery pack 8 and the reference terminal GND; the above-mentioned resistive dividers define a negative output terminal Out⁻, respectively, positive output terminal Out⁺ of the GFD stage 30.

Specifically, each of the first and second circuit branches 32, 33 comprises a first resistive divider block 32a, 33a connected between the negative terminal HV⁻, respectively the positive terminal HV⁺ of the battery pack 8 and the negative output terminal Out⁻, respectively, the positive output terminal Out⁺ of the GFD stage 30; and a second resistive divider block 32b, 33b connected between the negative output terminal Out⁻, respectively, the positive output terminal Out⁺ of the GFD stage 30 and the above-mentioned reference terminal GND.

As schematically illustrated, the negative and positive output terminals Out⁻, Out⁺ are also connected to the control unit 31 of the BMS module 10.

More specifically, the first resistive divider block 32a, 33a of each of the circuit branches 32, 33 consists of a first series resistor 35', connected between the negative terminal HV⁻, respectively positive terminal HV⁺ of the battery pack 8 and a respective internal node $N_{in}$; a second series resistor 35'', connected between the respective internal node $N_{in}$ and the negative output terminal Out⁻, respectively, positive output terminal Out⁺ of the GFD stage 30; and a respective switch element 36, connected in parallel to the first series resistor 35' and controlled by a respective control signal $S_c$.

As schematically illustrated, the control signals $S_c$ may be provided by the above-mentioned control unit 31 of the BMS module 10, in accordance with an operation logic (described in detail below).

In particular, the first and second series resistors 35', 35'' have, in the implementation described, a same resistance value R, for example 3 MΩ ± 1%.

The above-mentioned resistive divider block 32b, 33b of the first and second circuit branches 32, 33 consists of a respective partition resistor 38, with a resistance value $R_p$, for example of 14 kΩ ± 1%.

The same Figure 3 schematically shows the presence of a partial or total interruption of isolation in the battery pack 8, due to a ground fault, schematically depicted by an isolation resistor 40, with resistance $R_{iso}$ that can be represented being connected between an isolation interruption point $P_{ISO}$ inside the battery pack 8, at a certain module or electrolytic cell 12, in which the fault has occurred, and ground (i.e., the above-mentioned reference terminal GND).

A first and second circuit meshes 42, 44 can thus be defined, in which a first, respectively a second, mesh currents $i_1$, $i_2$ flow (due to the dispersion, or leakage, towards ground). In particular, an unbalancing is caused with respect to a balanced condition (in the absence of ground faults and electric isolation interruption), in particular between the values of the voltages $V_{Out}⁻$ and $V_{Out}⁺$ at the negative output terminal Out⁻, respectively, the positive output terminal Out⁺ of the GFD stage 30.

Specifically, the first circuit mesh 42 consists of the electrolytic cells 12 that are connected in series between the negative terminal HV⁻ of the battery pack 8 and the isolation interruption point $P_{ISO}$, the above-mentioned isolation resistor 40 and the first circuit branch 32 of the GFD stage 30.

The second circuit mesh 44 consists of the remaining electrolytic cells 12 of the battery pack 8 in series between the above-mentioned isolation interruption point $P_{ISO}$ and the positive terminal HV⁺ of the same battery pack 8, the above-mentioned isolation resistor 40 and the second circuit branch 33 of the GFD stage 30.

The above-mentioned isolation resistor 40 is, thus, shared between the first and second circuit meshes 42, 44.

As indicated above, according to one aspect of the present solution, the GFD stage 30 allows both to estimate the resistance value $R_{iso}$ of the isolation resistor 40 and to locate the position of the isolation interruption point $P_{ISO}$ inside the battery pack 8, by means of the analysis of at least one (advantageously, both) of the above-mentioned first and second circuit meshes 42, 44.

In this regard, and initially considering, by way of example, the first circuit mesh 42, the mesh equation in a first operating condition, wherein the respective switch element 36 is open (the switch element 36 of the second circuit mesh 44 being closed), is the following:

$$V_x - (R_P + 2 \cdot R) \cdot i_{1a} + R_{iso} \cdot (i_{2a} - i_{1a}) = 0$$

where $V_x$ indicates the voltage across the electrochemical cells 12 that are part of this first circuit mesh 42 (in series between the negative terminal HV⁻ of the battery pack 8 and the isolation interruption point $P_{ISO}$), $i_{1a}$ indicates the current circulating in the first circuit mesh 42 in the first operating condition and $i_{2a}$ indicates the current circulating in the second circuit mesh 44 in the same first operating condition ($i_{2a}$ - $i_{1a}$ being, thus, the current that flows in the isolation resistor 40 in this first operating condition).

Similarly, one can define, for the same first circuit mesh 42, the mesh equation in a second operating condition, wherein the respective switch element 36 is closed (again, the switch element 36 of the second circuit mesh 44 being closed):

$$V_x - (R_P + R) \cdot i_{1b} + R_{iso} \cdot (i_{2b} - i_{1b}) = 0$$

where $i_{1b}$ indicates the current circulating in the first circuit mesh 42 in the second operating condition and $i_{2b}$ indicates the current circulating in the second circuit mesh 44 in the same second operating condition ($i_{2b}$ - $i_{1b}$ being, thus, the current flowing in the isolation resistor 40 in this second operating condition).

Thus, two equations with two unknowns are obtained, $V_x$ and $R_{iso}$, that may be resolved, for example, to obtain the following expression for the resistance $R_{iso}$:

$$R_{iso} = \frac{(R \cdot i_{1b}) - (2 \cdot R \cdot i_{1a}) + R_p \cdot (i_{1b} - i_{1a})}{i_{2b} - i_{1b} - i_{2a} + i_{1a}}$$

In particular, it is underlined that the resistances $R$ and $R_p$ are of a known value, based on design data of the GFD stage 30.

In addition, the values of the currents circulating in the first and second circuit meshes 42, 44, in the first and second operating conditions (specifically, $i_{1a}$, $i_{1b}$, $i_{2a}$, $i_{2b}$) may be calculated based on the values of the voltages $V_{Out}^-$ and $V_{Out}^+$ at the negative output terminal Out⁻, respectively, the positive output terminal Out⁺ of the GFD stage 30 and of the known value of the above-mentioned resistance $R_p$, in particular by means of the following relations:

$$i_1 = \frac{V_{out}^-}{R_p}, i_2 = \frac{V_{out}^+}{R_p}$$

The value of the unknown voltage $V_x$ can, thus, be obtained as a function of the value previously calculated for the resistance $R_{iso}$, using the mesh equations previously indicated.

Advantageously, based on this value of the unknown voltage $V_x$ it is also possible to calculate the position of the isolation inside the battery pack 8, or locate the above-mentioned isolation interruption point $P_{ISO}$.

For example, the following expression can be used to estimate the position of the isolation interruption point $P_{ISO}$:

$$P_{iso} = \frac{V_x}{V_{cell\_av}}$$

where $V_{cell\_av}$ indicates an average cell voltage value of the electrochemical cells 12 of the battery pack 8 (for example a pre-set or design value).

Alternatively, should the voltage drops on the individual electrochemical cells 12 be know (for example, using the information provided by the cell supervisor circuit 18 of the battery pack 8), the above-mentioned position of the isolation interruption point $P_{ISO}$ could be calculated as a function of the value of the unknown voltage $V_x$ and of the measured value of the voltage drops on the electrochemical cells 12 of the circuit mesh being analysed (in this case, the cells starting from the negative terminal HV⁻).

What was described in detail for the first circuit mesh 42 may clearly be applied in an entirely similar manner for the second circuit mesh 44, with clear changes in the mesh equations to take into account the corresponding circuit components.

In one possible embodiment, the control unit 31 of the BMS module 10 is also configured, in cooperation with the GFD stage 30, to calculate the above-mentioned value of the resistance $R_{iso}$ of the isolation resistor 40 and locate the position of the isolation interruption point $P_{ISO}$, as a function of the above-mentioned values of the voltages $V_{Out}^-$ and $V_{Out}^+$ received as inputs by the negative output terminal Out⁻, respectively, the positive output terminal Out⁺ of the same GFD stage 30.

To this end, the control unit 31 is designed to implement suitable software instructions of a processing program stored in a corresponding non-volatile memory (not illustrated here).

In particular, the control unit 31 is configured to control the opening of the respective switch element 36 of the first and/or second circuit branches 32, 33, so as to implement the above-mentioned first and second operating conditions and, consequently, allow the possibility to assess the two mesh equations previously discussed, for estimating the value and position of the isolation resistance.

An additional aspect of the present solution envisages that, for the calculation of the above-mentioned value of the resistance $R_{iso}$ of the isolation resistor 40 and for locating the position of the isolation interruption point $P_{ISO}$, the first circuit mesh 42 or the second circuit mesh 44 is alternatively used, depending on the different unbalance detected between the first and second circuit meshes 42, 44 (in other words, as a function of the different values of the first, respectively second, mesh currents $i_1$, $i_2$).

In particular, the above-mentioned control unit 31 may be, in this case, configured to carry out a preliminary evaluation of the value of the mesh currents $i_1$, $i_2$ (under the same operating conditions, whether the first or second operating condition) and use the first circuit mesh 42 if the first mesh current $i_1$ is greater than the second mesh current $i_2$, or the second circuit mesh 44 if the first mesh current $i_1$ is less than the second mesh current $i_2$ (if the two current values are basically equal, the first or the second circuit mesh 42, 44 may be chosen).

This preliminary evaluation may, advantageously, allow to increase precision in estimating the value of the isolation resistance and, in addition, in locating the fault inside the battery pack 8.

Alternatively, the above-mentioned preliminary evaluation may be carried out as a function of the isolation resistance values measured (in a known way, not described in detail here) at the positive and negative terminals HV⁺, HV⁻ of the battery pack 8.

In particular, the first circuit mesh 42 may be, in this case, used for the evaluation of the isolation if the value of the isolation resistance at the negative terminal HV⁻ of the battery pack 8 is greater than the isolation resistance at the positive terminal HV⁺; similarly, the second circuit mesh 44 may be used if the value of the isolation resistance at the negative terminal HV⁻ of the battery pack 8 is less than the isolation resistance at the positive terminal HV⁺.

It may also be seen that the measurements made in relation to the isolation resistance may be implemented at pre-defined intervals or at the occurrence of particular events, for example if the measurements taken relating to the isolation resistances at the positive and negative terminals HV⁺, HV⁻ of the battery pack 8 is indicative of a possible ground fault (the type of algorithm that can be implemented being selectable).

The advantages that this solution enables are evident from what has been discussed.

In particular, the solution described allows to determine, in case of an isolation loss in the battery pack, not just an estimate of the resulting isolation resistance, but also to locate, during a diagnosis phase, the position of the isolation loss inside the same battery pack.

In this regard, the present Applicant has demonstrated, with simulations and experimental tests, the possibility of obtaining very accurate estimates of the isolation resistance value, as well as excellent precision in locating the isolation loss inside the battery pack.

This solution thus allow not only to implement suitable actions to limit the risks, for example disconnecting the battery pack from loads by opening the contactors coupled to the positive and negative terminals of the battery pack; but also to implement targeted strategies to repair faults, for example with the possibility of replacing one or more modules inside the battery pack and not the whole battery pack (with clear benefits both in terms of costs and time).

Lastly, it is clear that modifications and variations may be made to that described herein without departing from the scope of the present invention, as set forth in the claims.

In particular, it is clear that the solution described can, advantageously, be applied in various fields of use, without being limited to applications for electric or hybrid vehicles, for example for drive batteries, used with the function of supplying drives and/or electric motors in industrial vehicles, robots, or electric machinery.

Claims

1. An isolation resistance evaluation system for a battery (5) of a vehicle (1), having a battery pack (8) with a plurality of electrolytic cells (12) connected in series between a positive terminal (HV$^+$) and a negative terminal (HV$^-$),

   comprising a ground fault detection stage (30) designed to be coupled to said positive terminal (HV$^+$) and to said negative terminal (HV$^-$) of the battery pack (8) and including: a first circuit branch (32) electrically coupled between the negative terminal (HV$^-$) of the battery pack (8) and a reference terminal (GND) connected to the ground of the vehicle (1); and a second circuit branch (33) electrically coupled between the positive terminal (HV$^+$) of the battery pack (8) and said reference terminal (GND), wherein the first and the second circuit branches (32, 33) implement a respective resistive divider connected between the negative terminal (HV$^-$), respectively the positive terminal (HV$^+$), of the battery pack (8) and the reference terminal (GND) and defining a negative output terminal (Out$^-$), respectively a positive output terminal (Out$^+$), of the ground fault detection stage (30) having, in use, a respective output voltage (V$_{Out}^-$, V$_{Out}^+$),
   **characterized by** comprising a control unit (31) operatively coupled to said negative output terminal (Out$^-$) and positive output terminal (Out$^+$) and configured, in cooperation with the ground fault detection stage (30), to determine an isolation resistance value ($R_{iso}$) associated with an isolation loss of the battery pack (8) and to locate an isolation loss position within the battery pack (8) as a function of the values of the output voltages (V$_{Out}^-$, V$_{Out}^+$) at the positive and negative output terminals (Out$^-$, Out$^+$) of the ground fault detection stage (30).

2. The system according to claim 1, wherein said first and second circuit branches (32, 33) are designed to form a first, respectively a second, circuit mesh (42, 44), with an isolation resistor (40), having said isolation resistance ($R_{iso}$) and connected between an isolation interruption point ($P_{ISO}$) within said battery (8), at said isolation loss position, and said reference terminal (GND), said isolation resistor (40) being shared by said first and second circuit meshes (42, 44); and wherein said ground fault detection stage (30) is configured to estimate the value of the isolation resistance ($R_{iso}$) and to locate the isolation loss position through the analysis of at least one of said first and second circuit meshes (42, 44).

3. The system according to claim 2, wherein said control unit (31) is configured to implement: a first operating condition of said ground fault detection stage (30), which is associated with a first mesh equation of said at least one of said first and second circuit meshes (42, 44); and a second operating condition of said ground fault detection stage (30), which is associated with a second mesh equation of said at least one of said first and second circuit meshes (42, 44); and wherein said first and second mesh equations form a system of two equations with two unknowns, corresponding to said value of the isolation resistance ($R_{iso}$) and to an isolation voltage ($V_x$) across the electrochemical cells (12) that are part of said at least one of said first and second circuit meshes (42, 44).

4. The system according to claim 3, wherein the position of the isolation interruption point ($P_{ISO}$) within the battery pack (8) is determined as:

$$P_{iso} = \frac{V_x}{V_{cell\_av}}$$

   wherein $V_x$ indicates said isolation voltage and $V_{cell\_av}$ indicates an average cell voltage value of the electrochemical cells (12) of the battery pack (8).

5. The system according to claim 3 or 4, wherein said first circuit mesh (42) is formed by the electrolytic cells (12) series-connected between the negative terminal (HV$^-$) of said battery pack (8) and the isolation interruption point ($P_{ISO}$), by the isolation resistor (40) and by said first circuit branch (32) of the ground fault detection stage (30); and said second circuit mesh (44) is formed by the remaining electrolytic cells (12) of said battery pack (8) series-connected between the isolation interruption point ($P_{ISO}$) and the positive terminal (HV$^+$) of the battery pack (8), by the isolation resistor (40) and by the second circuit branch (33) of the ground fault detection stage (30).

6. The system according to any of claims 3-5, wherein said respective resistive divider comprises a first resistive divider block (32a, 33a) connected between the negative terminal (HV$^-$), respectively the positive terminal (HV$^+$), of the battery pack (8) and the negative output terminal (Out$^-$), respectively the positive output terminal (Out$^+$), of the ground fault detection stage (30); and a second resistive divider block (32b, 33b) connected between the negative output terminal (Out$^-$), respectively the positive output terminal (Out$^+$), of the ground fault detection stage (30) and said reference terminal (GND).

7. The system according to claim 6, wherein said first resistive divider block (32a, 33a) is formed by a first series resistor (35') connected between the negative terminal (HV⁻), respectively the positive terminal (HV⁺), of the battery pack (8) and a respective internal node ($N_{in}$); a second series resistor (35") connected between the respective internal node ($N_{in}$) and the negative output terminal (Out⁻), respectively the positive output terminal (Out⁺), of the ground fault detection stage (30); and a respective switch element (36) connected in parallel to the first series resistor (35') and controlled by a respective control signal ($S_c$); wherein said control unit (31) is configured to provide said respective control signal ($S_c$) in order to implement said first operating condition, corresponding to a first operating state, either open or closed, of said respective switch element (36), and said second operating condition, corresponding to a second operating state, either open or closed, different from said first operating state, of said respective switch element (36) .

8. The system according to any of claims 2-7, wherein said ground fault detection stage (30) is configured to estimate the value of the isolation resistance ($R_{iso}$) and to locate the isolation loss position, alternatively through the analysis of the first circuit mesh (42) or of the second circuit mesh (44), as a function of a different unbalance detected between said first and second circuit meshes (42, 44) relative to a balanced condition in the absence of ground faults and electric isolation interruption.

9. A battery (5) for a vehicle (1) having a battery pack (8) with a plurality of electrolytic cells (12) connected in series between a positive terminal (HV⁺) and a negative terminal (HV⁻) and a BMS module (10), operatively coupled to the battery pack (8) for managing and controlling operation thereof; further comprising an isolation resistance evaluation system according to any of the preceding claims.

10. The battery (5) according to claim 9, wherein said BMS module (10) includes said isolation resistance evaluation system.

11. The battery (5) according to claim 9 or 10, of a high-voltage type, with an operating voltage between said positive terminal (HV⁺) and negative terminal (HV⁻) in the range 400-800 V.

12. A motor vehicle (1) having wheels (3) resting on the ground and comprising: an electric or hybrid drive assembly (4) designed to cause rotation of at least one of said wheels (3); and a battery (5) according to any one of claims 9-11, designed to store a given quantity of electrical energy to be supplied to said drive assembly (4).

13. An isolation resistance evaluation method for a battery (5) of a vehicle (1) having a battery pack (8) with a plurality of electrolytic cells (12) connected in series between a positive terminal (HV⁺) and a negative terminal (HV⁻),

comprising defining a first circuit branch (32) electrically coupled between the negative terminal (HV⁻) of the battery pack (8) and a reference terminal (GND) connected to the ground of the vehicle (1); and a second circuit branch (33) electrically coupled between the positive terminal (HV⁺) of the battery pack (8) and said reference terminal (GND), wherein the first and the second circuit branches (32, 33) implement a respective resistive divider connected between the negative terminal (HV⁻), respectively the positive terminal (HV⁺), of the battery pack (8) and the reference terminal (GND), defining a negative output terminal (Out⁻), respectively a positive output terminal (Out⁺), having in use a respective output voltage $V_{Out}{}^-$, $V_{Out}{}^+$),
**characterized by** comprising: determining an isolation resistance value ($R_{iso}$) associated with an isolation loss of the battery pack (8) and locating an isolation loss position inside the battery pack (8), as a function of the values of the output voltages ($V_{Out}{}^-$, $V_{Out}{}^+$) at the positive and negative output terminals (Out⁻, Out⁺).

14. The method according to claim 13, wherein said first and second circuit branches (32, 33) are designed to form a first and, respectively, a second circuit mesh (42, 44) with an isolation resistor (40) having said isolation resistance ($R_{iso}$) and connected between an isolation interruption point ($P_{ISO}$) inside said battery (8), at said isolation loss position, and said reference terminal (GND), said isolation resistor (40) being shared by said first and second circuit meshes (42, 44); comprising estimating the value of the isolation resistance ($R_{iso}$) and locating the isolation loss position through the analysis of at least one of said first and second circuit meshes (42, 44).

15. The method according to claim 14, wherein estimating comprising implementing: a first operating condition of said ground fault detection stage (30), which is associated with a first mesh equation of said at least one of said first and second circuit meshes (42, 44); and a second operating condition of said ground fault detection stage (30), which is associated with a second mesh equation of said at least one of said first and second circuit meshes (42, 44); and wherein said first and second mesh equations form a system of two equations with two unknowns, corresponding to said value of the isolation resistance ($R_{iso}$) and to an isolation voltage ($V_x$) across the electrochemical cells (12) that are part of said at least one of said first and second circuit meshes (42, 44).

FIG. 1

EP 4 556 914 A1

FIG. 2

EP 4 556 914 A1

FIG. 3

Europäisches
Patentamt

European
Patent Office

Office européen
des brevets

# EUROPEAN SEARCH REPORT

**Application Number**

EP 24 21 2623

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 106 997 007 A (SHANGHAI ZHIYUN NEW ENERGY TECH CO LTD) 1 August 2017 (2017-08-01) | 1-6,8-15 | INV. G01R27/02 B60L3/00 |
| A | * paragraphs [0041] - [0082]; claims 1-9; figures 1-3 * | 7 | |
| X | WO 2020/135703 A1 (SVOLT ENERGY TECH CO LTD [CN]) 2 July 2020 (2020-07-02) | 1-6,9-15 | |
| A | * page 7 - page 13; claims 1-10; figures 1-6C * | 7,8 | |
| X | CN 106 501 611 A (SHENZHEN HANGSHENG ELECTRONICS) 15 March 2017 (2017-03-15) | 1-3,5-7, 9-15 | |
| A | * paragraphs [0042] - [0091]; claims 1-8; figures 1-3 * | 4,8 | |
| X | CN 114 200 210 A (PEARL HAIGE ELECTRIC APPLIANCE CO LTD) 18 March 2022 (2022-03-18) | 1-3,5,6, 8-15 | |
| A | * paragraphs [0059] - [0154]; claims 1-15; figures 1-13 * | 4,7 | **TECHNICAL FIELDS SEARCHED (IPC)** |
| X | CN 111 060 748 A (GREE ELECTRIC APPLIANCES INC ZHUHAI) 24 April 2020 (2020-04-24) | 1-3,5,6, 8-15 | G01R B60L |
| A | * paragraphs [0053] - [0148]; claims 1-10; figures 1-11 * | 4,7 | |
| X | CN 113 791 278 A (SVOLT ENERGY TECH CO LTD) 14 December 2021 (2021-12-14) | 1-7,9-15 | |
| A | * paragraphs [0047] - [0092]; claims 1-10; figures 1-5 * | 8 | |

The present search report has been drawn up for all claims

| Place of search | Date of completion of the search | Examiner |
|---|---|---|
| Munich | 3 March 2025 | Bilzer, Claus |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

........................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 21 2623

This annex lists the patent family members relating to the patent documents cited in the above-mentioned European search report.
The members are as contained in the European Patent Office EDP file on
The European Patent Office is in no way liable for these particulars which are merely given for the purpose of information.

03-03-2025

| Patent document cited in search report | | Publication date | Patent family member(s) | | Publication date |
|---|---|---|---|---|---|
| CN 106997007 | A | 01-08-2017 | NONE | | |
| WO 2020135703 | A1 | 02-07-2020 | CN | 109720235 A | 07-05-2019 |
| | | | WO | 2020135703 A1 | 02-07-2020 |
| CN 106501611 | A | 15-03-2017 | NONE | | |
| CN 114200210 | A | 18-03-2022 | NONE | | |
| CN 111060748 | A | 24-04-2020 | NONE | | |
| CN 113791278 | A | 14-12-2021 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IT 102023000024207